(19) Europäisches Patentamt
European Patent Office
Office européen des brevets

(11) EP 4 122 994 B1

(12) **EUROPEAN PATENT SPECIFICATION**

(45) Date of publication and mention of the grant of the patent:
**25.03.2026 Bulletin 2026/13**

(21) Application number: **21936250.6**

(22) Date of filing: **20.04.2021**

(51) International Patent Classification (IPC):
***C09K 3/14*** *(2006.01)* ***B24B 37/04*** *(2012.01)*
***H01L 21/321*** *(2006.01)* ***C09G 1/02*** *(2006.01)*

(52) Cooperative Patent Classification (CPC):
**C09K 3/1409; B24B 37/044; C09G 1/02; C09K 3/1463; H10P 52/403**

(86) International application number:
**PCT/JP2021/016073**

(87) International publication number:
**WO 2022/224357 (27.10.2022 Gazette 2022/43)**

(54) **POLISHING METHOD**

POLIERVERFAHREN

PROCÉDÉ DE POLISSAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**25.01.2023 Bulletin 2023/04**

(73) Proprietor: **Resonac Corporation**
**Tokyo 105-7325 (JP)**

(72) Inventors:
- **KOMINE, Mayumi**
**Tokyo**
**1006606 (JP)**
- **YAMASHITA, Takashi**
**Tokyo**
**1006606 (JP)**
- **MINAMI, Hisataka**
**Tokyo**
**1006606 (JP)**

(74) Representative: **Hoffmann Eitle**
**Patent- und Rechtsanwälte PartmbB**
**Arabellastraße 30**
**81925 München (DE)**

(56) References cited:
**JP-A- 2016 017 149**
**JP-A- 2016 017 150**
**JP-A- 2016 531 429**
**JP-A- 2017 110 177**
**JP-A- 2017 139 349**
**JP-A- 2019 143 119**
**US-A1- 2016 053 381**
**US-B2- 7 247 567**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Technical Field

The present invention relates to a polishing method.

### Background Art

In the field of semiconductor production, with achievement of high performance of memory devices (ultra LSI devices and the like), a miniaturization technology as an extension of the conventional technology finds restriction in allowing high integration and speed-up to be compatible with each other. Accordingly, while miniaturization of semiconductor elements is being promoted, techniques for allowing vertical high integration (namely, techniques for developing multilayered wiring, elements, and the like) have been developed.

In the process for producing a device including multilayered wiring, elements, and the like, one of the most important techniques is a CMP (chemical mechanical polishing) technique. The CMP technique is a technique in which a thin film is formed on a substrate by chemical vapor deposition (CVD) or the like to obtain a base substrate, and then the surface of this base substrate is flattened. When the surface of the base substrate after being flattened has irregularities, there occur, for example, such troubles that the focusing in an exposure step is precluded, or a fine wiring structure cannot be sufficiently formed. The CMP technique is also applied, in a production process of a device, to a step of forming an element isolation region by polishing a plasma oxide film (such as BPSG, HDP-$SiO_2$, or p-TEOS), a step of forming an interlayer insulating film, a step of flattening a plug (for example, Al·Cu plug) after a silicon oxide film (a film containing silicon oxide) is embedded in a metal wiring, or the like.

CMP is usually performed using an apparatus capable of supplying a CMP polishing liquid onto a polishing pad. The surface of a base substrate is polished by pressing the base substrate against the polishing pad while the CMP polishing liquid is supplied between the surface of the base substrate and the polishing pad. In the CMP technique, a high-performance CMP polishing liquid is one of elemental technologies and various CMP polishing liquids have also been hitherto developed (see, for example, Patent Literature 1 below).
Patent Literature 2 describes a method of polishing germanium comprising the step of abrading the surface of a substrate comprising germanium with an aqueous chemical mechanical polishing (CMP) composition comprising an oxidizing agent, a particulate abrasive, and a germanium etching inhibitor comprising a cationic polymer selected from the group consisting of poly(diallyldimethylammonium) chloride (polyDADMAC), poly(methacryloyloxyethyltrimethylammonium)-chloride (polyMADQUAT), poly(dimethylamine-co-epichlorohydrin-coethylenediamine) (polyDEE), and a copolymer of acrylamide and DADMAC, plus an amino acid selected from the group consisting of lysine, arginine, histidine, glycine, beta-alanine, tricine, and valine, wherein the polymer is present in the CMP composition at a concentration in the range of about 10 to about 2000 ppm.

### Citation List

### Patent Literature

Patent Literature 1: Japanese Unexamined Patent Publication No. 2013-175731
Patent Literature 2: US 2016/053381 A1

## Summary of Invention

### Technical Problem

Incidentally, in a step of forming an element isolation region on a substrate, a material to be polished is formed so as to fill irregularities having been provided in advance on the surface of the substrate. Thereafter, the surface of the material to be polished is flattened by CMP to form an element isolation region. In a case where the material to be polished is formed on the substrate of which irregularities for obtaining an element isolation region are provided on the surface, irregularities corresponding to the irregularities of the substrate are also generated on the surface of the material to be polished. In the polishing of the surface having irregularities, while a convex portion is preferentially removed, a concave portion is slowly removed so as to flatten the surface.

For the purpose of enhancing the throughput of the semiconductor production, it is preferable that the unnecessary portion of the material to be polished formed on the substrate is removed as rapidly as possible. For

example, with high integration of a memory, in the case of manufacturing 3D-NAND, it is required to remove polysilicon provided as a gate or the like on a substrate at a high polishing rate. Therefore, the CMP polishing liquid is required to polish polysilicon at a high polishing rate.

An object of an aspect of the present invention is to provide a polishing method using a CMP polishing liquid capable of obtaining a high polishing rate for polysilicon.

**Solution to Problem**

An aspect of the present invention provides a polishing method including a step of polishing a material to be polished which contains polysilicon by using a CMP polishing liquid for polishing polysilicon, the CMP polishing liquid containing: abrasive grains; and a cationic polymer, in which the cationic polymer includes at least one selected from the group consisting of a polymer A having a main chain containing a nitrogen atom and a carbon atom and a hydroxyl group bonded to the carbon atom and an allylamine polymer B having at least one selected from the group consisting of a structure unit represented by General Formula (I) below, a structure unit represented by General Formula (II) below, a structure unit represented by General Formula (III) below, a structure unit represented by General Formula (IV) below, and a structure unit represented by General Formula (V) below:

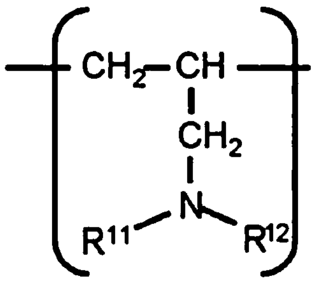

(I)

wherein, in formula (I), $R^{11}$ and $R^{12}$ each independently represent a hydrogen atom, an alkyl group, or an aralkyl group, and the amino group may form an acid addition salt,

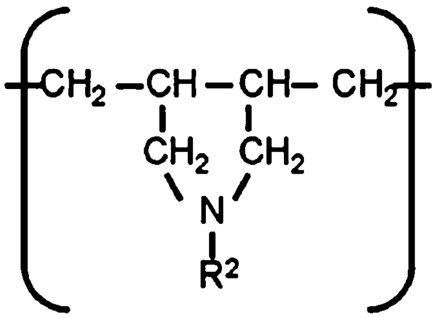

(II)

wherein, in formula (II), $R^2$ represents a hydrogen atom, an alkyl group, or an aralkyl group, and the nitrogen-containing ring may form an acid addition salt,

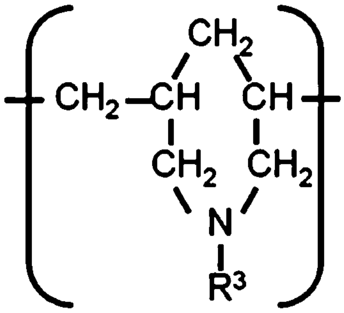

( III )

wherein, in formula (III), $R^3$ represents a hydrogen atom, an alkyl group, or an aralkyl group, and the nitrogen-containing ring may form an acid addition salt,

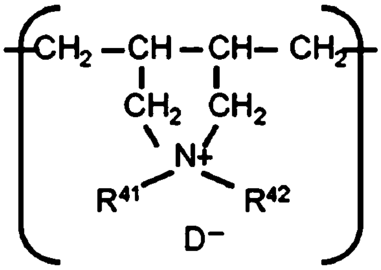

( IV )

wherein, in formula (IV), $R^{41}$ and $R^{42}$ each independently represent a hydrogen atom, an alkyl group, or an aralkyl group, and $D^-$ represents a monovalent anion,

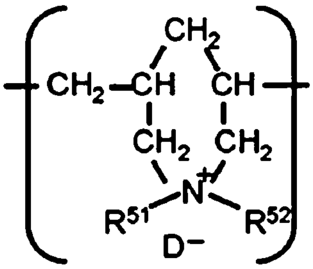

( V )

wherein, in formula (V), $R^{51}$ and $R^{52}$ each independently represent a hydrogen atom, an alkyl group, or an aralkyl group, and $D^-$ represents a monovalent anion.

According to such a polishing method, a high polishing rate for polysilicon can be obtained.

**Advantageous Effects of Invention**

According to the present invention, it is possible to provide a polishing method using a CMP polishing liquid capable of obtaining a high polishing rate for polysilicon.

**Description of Embodiments**

Hereinafter, an embodiment of the present invention will be described in detail. However, the present invention is not limited to the following embodiment and can be modified variously within the scope of the claims and carried out.

In the present specification, a numerical range that has been indicated by use of "to" indicates the range that includes the numerical values which are described before and after "to", as the minimum value and the maximum value,

respectively. In the numerical ranges that are described stepwise in the present specification, the upper limit value or the lower limit value of the numerical range of a certain stage can be arbitrarily combined with the upper limit value or the lower limit value of the numerical range of another stage. In the numerical ranges that are described in the present specification, the upper limit value or the lower limit value of the numerical range may be replaced with the value shown in Examples. "A or B" may include either one of A and B, and may also include both of A and B. Materials listed as examples in the present specification can be used singly or in combinations of two or more, unless otherwise specifically indicated. In the present specification, when a plurality of substances corresponding to each component exist in the composition, the used amount of each component in the composition means the total amount of the plurality of substances that exist in the composition, unless otherwise specified. In the present specification, the term "film" includes a structure having a shape which is formed on a part, in addition to a structure having a shape which is formed on the whole surface, when the film has been observed as a plan view. In the present specification, the term "step" includes not only an independent step but also a step by which an intended action of the step is achieved, even though the step cannot be clearly distinguished from other steps.

<CMP polishing liquid>

A CMP polishing liquid (polishing liquid for CMP) for use in the method of the present invention is a CMP polishing liquid for polishing polysilicon. The CMP polishing liquid for use in the method of the present invention contains abrasive grains (polishing particles) and a cationic polymer, and the cationic polymer includes at least one selected from the group consisting of a polymer A having a main chain containing a nitrogen atom (N atom) and a carbon atom (C atom) and a hydroxyl group bonded to the carbon atom and an allylamine polymer B as defined in claim 1 (hereinafter, referred to as "polymer B") (hereinafter, collectively referred to as "specific cationic polymer"). The specific cationic polymer of the CMP polishing liquid for use in the method of the present embodiment may be a CMP polishing liquid including the polymer A and the polymer B, a CMP polishing liquid including the polymer A but not including the polymer B, or a CMP polishing liquid including the polymer B but not including the polymer A.

According to the CMP polishing liquid for use in the method of the present embodiment, a high polishing rate for polysilicon can be obtained. According to the CMP polishing liquid for use in the method of the present embodiment, a polishing rate for polysilicon of 1200 Å/min or more can be obtained in an evaluation method described in Examples. Although a factor responsible for obtaining a high polishing rate for polysilicon is not necessarily clear, the factor is presumed as described below. However, the factor is not limited to the contents to be as follows. That is, the specific cationic polymer is adsorbed to the surface of polysilicon to generate polarity at the silicon-silicon bond of polysilicon. Thereby, it is presumed that the bond is likely to be cleaved with embrittlement, and thus a high polishing rate for polysilicon is obtainable.

According to the CMP polishing liquid for use in the method of the present embodiment, a polishing rate for silicon oxide can also be suppressed while a high polishing rate for polysilicon is obtained. According to the CMP polishing liquid for use in the method of the present embodiment, in the evaluation method described in Examples, a polishing rate ratio of polysilicon with respect to silicon oxide (the polishing rate for polysilicon/the polishing rate for silicon oxide) can be 1 or more (for example, 3 or more).

According to the CMP polishing liquid for use in the method of the present embodiment, a polishing rate ratio of silicon nitride with respect to silicon oxide (the polishing rate for silicon nitride/the polishing rate for silicon oxide) can also be increased. According to the CMP polishing liquid for use in the method of the present embodiment, in the evaluation method described in Examples, the polishing rate ratio of silicon nitride with respect to silicon oxide can be 0.2 or more (for example, 0.5 or more).

It is sufficient for the CMP polishing liquid for use in the method of the present embodiment to obtain a high polishing rate for polysilicon when polysilicon is polished, and the CMP polishing liquid is used for polishing a material to be polished which contains polysilicon. The CMP polishing liquid for use in the method of the present embodiment may be used for polishing polysilicon and silicon nitride. The CMP polishing liquid for use in the method of the present embodiment may be used for polishing polysilicon and silicon oxide, or polishing polysilicon, silicon nitride, and silicon oxide.

(Abrasive grains)

The abrasive grains can contain, for example, a cerium-based compound, alumina, silicon oxide (silica), titania, zirconia, magnesia, mullite, silicon nitride, α-sialon, aluminum nitride, titanium nitride, silicon carbide, boron carbide, or the like. The constituent components of the abrasive grains can be used singly or in combination of two or more types thereof. The abrasive grains may contain at least one selected from the group consisting of a cerium-based compound and silicon oxide from the viewpoint of easily obtaining a high polishing rate for polysilicon and the viewpoint of easily suppressing a polishing rate for silicon oxide.

Incidentally, when 3D-NAND is manufactured, it is required to remove polysilicon and silicon nitride at a high polishing rate in some cases. In this regard, conventionally, since it is difficult to simultaneously polish polysilicon and

silicon nitride by using one CMP polishing liquid at a high polishing rate, polishing is performed by using different kinds of CMP polishing liquids while dividing the polishing into two stages of a step of polishing polysilicon and a step of polishing silicon nitride. However, from the viewpoint of improving productivity and simplifying facilities, it is required to perform finishing with one-stage polishing. In this regard, in the CMP polishing liquid for use in the method of the present embodiment, when the abrasive grains contain a cerium-based compound, a high polishing rate for polysilicon and silicon nitride can be obtained, and a polishing rate for silicon oxide can be suppressed while a high polishing rate for silicon nitride is obtained.

Examples of the cerium-based compound include cerium oxide (ceria), cerium hydroxide, cerium ammonium nitrate, cerium acetate, cerium sulfate hydrate, cerium bromate, cerium bromide, cerium chloride, cerium oxalate, cerium nitrate, and cerium carbonate. The cerium-based compound may include cerium oxide from the viewpoint of easily obtaining a high polishing rate for polysilicon and silicon nitride, the viewpoint of easily suppressing a polishing rate for silicon oxide, and the viewpoint of easily obtaining a polished surface with less polishing scratches.

In the case of using cerium oxide, the abrasive grains may contain polycrystalline cerium oxide having a crystal grain boundary (for example, polycrystalline cerium oxide having multiple crystallites surrounded by crystal grain boundaries). It is considered that, such a polycrystalline cerium oxide particle is different from a simple aggregate in which single crystal particles aggregate, is made fine by the stress during polishing, and at the same time allows active surfaces (the surfaces not exposed to outside before being made fine) to appear one after another, so that a high polishing rate for a material to be polished can be highly maintained.

Examples of the method for producing abrasive grains containing cerium oxide include liquid phase synthesis; and a method performing oxidation by firing, or hydrogen peroxide or the like. In the case of obtaining abrasive grains containing the polycrystalline cerium oxide having a crystal grain boundary, a method in which a cerium source such as cerium carbonate is fired can be used. The temperature at the time of firing may be, for example, 350 to 900°C. In a case where the produced cerium oxide particles aggregate, the aggregated cerium oxide particles may be mechanically pulverized.

In a case where the abrasive grains contain a cerium-based compound (for example, cerium oxide), the content of the cerium-based compound in the abrasive grains may be 50% by mass or more, 70% by mass or more, 90% by mass or more, 95% by mass or more, 97% by mass or more, 99% by mass or more, or substantially 100% by mass (an embodiment in which the abrasive grains are substantially composed of a cerium-based compound), on the basis of the whole of the abrasive grains (the whole of the abrasive grains contained in the CMP polishing liquid), from the viewpoint of easily obtaining a high polishing rate for polysilicon and silicon nitride, and the viewpoint of easily suppressing a polishing rate for silicon oxide.

In a case where the abrasive grains contain silicon oxide, the content of silicon oxide in the abrasive grains may be 50% by mass or more, 70% by mass or more, 90% by mass or more, 95% by mass or more, 97% by mass or more, 99% by mass or more, or substantially 100% by mass (an embodiment in which the abrasive grains are substantially composed of silicon oxide), on the basis of the whole of the abrasive grains (the whole of the abrasive grains contained in the CMP polishing liquid), from the viewpoint of easily obtaining a high polishing rate for polysilicon and the viewpoint of easily suppressing a polishing rate for silicon oxide.

The content of a hydroxide in the abrasive grains (for example, the content of cerium hydroxide) may be 0.01% by mass or less, 0.001% by mass or less, or 0.0001% by mass or less, on the basis of the whole of the abrasive grains (the whole of the abrasive grains contained in the CMP polishing liquid). The abrasive grains may not contain a hydroxide (for example, cerium hydroxide) (the content of hydroxide (for example, the content of cerium hydroxide) may be substantially 0% by mass).

The average particle diameter of the abrasive grains in the CMP polishing liquid may be in the following range. The average particle diameter of the abrasive grains may be 50 nm or more, 70 nm or more, more than 70 nm, 75 nm or more, 80 nm or more, 85 nm or more, or 90 nm or more, from the viewpoint of easily obtaining a high polishing rate for polysilicon and silicon nitride. The average particle diameter of the abrasive grains may be 500 nm or less, 300 nm or less, 280 nm or less, 250 nm or less, 200 nm or less, 180 nm or less, 160 nm or less, 150 nm or less, 120 nm or less, 100 nm or less, or 90 nm or less, from the viewpoint of easily suppressing polishing scratches. From these viewpoints, the average particle diameter of the abrasive grains may be 50 to 500 nm.

In order to control the average particle diameter of the abrasive grains, conventionally known methods can be used. By taking the cerium oxide particles as an example, examples of the method of controlling the average particle diameter of the abrasive grains include the control of the firing temperature, the firing time, the pulverization condition, or the like mentioned above; and the application of filtration, classification, or the like.

As the average particle diameter of the abrasive grains, an arithmetic average diameter measured by a laser diffraction/scattering type particle size distribution analyzer can be used. The average particle diameter of the abrasive grains can be measured, for example, using LA-920 (trade name) manufactured by HORIBA, Ltd., or the like by the method described in Examples.

The content of the abrasive grains may be in the following range with respect to 100 parts by mass of the CMP

polishing liquid. The content of the abrasive grains may be 0.01 parts by mass or more, 0.05 parts by mass or more, 0.08 parts by mass or more, 0.1 parts by mass or more, 0.15 parts by mass or more, 0.2 parts by mass or more, 0.3 parts by mass or more, 0.5 parts by mass or more, 0.8 parts by mass or more, 1.0 part by mass or more, 1.5 parts by mass or more, or 2.0 parts by mass or more, from the viewpoint of easily obtaining a high polishing rate for polysilicon and silicon nitride. The content of the abrasive grains may be 10 parts by mass or less, 5.0 parts by mass or less, 3.0 parts by mass or less, 2.0 parts by mass or less, less than 2.0 parts by mass, 1.5 parts by mass or less, 1.0 part by mass or less, 0.8 parts by mass or less, or 0.5 parts by mass or less, from the viewpoint of easily suppressing the aggregation of the abrasive grains and the viewpoint of easily suppressing a polishing rate for silicon oxide. From these viewpoints, the content of the abrasive grains may be 0.01 to 10 parts by mass, 0.1 to 10 parts by mass, or 0.1 to 2 parts by mass.

(Cationic polymer)

The CMP polishing liquid for use in the method of the present embodiment contains a specific cationic polymer including at least one selected from the group consisting of the polymer A having a main chain containing a nitrogen atom and a carbon atom and a hydroxyl group bonded to the carbon atom and the polymer B (an allylamine polymer as defined in claim 1; excluding a compound corresponding to the polymer A). The CMP polishing liquid for use in the method of the present embodiment may or may not contain a cationic polymer other than the specific cationic polymer. The "cationic polymer" is defined as a polymer having a cation group or a group which can be ionized to a cation group. Examples of the cation group include an amino group and an imino group. The cationic polymer (for example, the specific cationic polymer) can be used singly or in combination of two or more types thereof.

The specific cationic polymer may be water soluble. By using a compound having a high degree of solubility in water, a desired amount of the specific cationic polymer can be satisfactorily dissolved in the CMP polishing liquid. The degree of solubility of the specific cationic polymer with respect to 100 g of water at room temperature (25°C) may be 0.005 g or more or 0.02 g or more. The upper limit of the degree of solubility is not particularly limited.

The specific cationic polymer may include, as the polymer A or the polymer B, a polymer P which has a main chain containing a carbon atom and a side chain bonded to the main chain and in which at least one selected from the group consisting of the main chain and the side chain contains a nitrogen atom, from the viewpoint of easily obtaining a high polishing rate for polysilicon and silicon nitride, and the viewpoint of easily suppressing a polishing rate for silicon oxide. The "main chain" refers to the longest molecular chain. The "side chain" refers to the molecular chain (for example, a molecular chain containing a carbon atom) branched from the main chain. The side chain may be bonded to a plurality of atoms (for example, two atoms) constituting the main chain.

The maximum value of the molecular weight of the side chain in the polymer P may be 100 or less, 80 or less, 60 or less, 50 or less, 40 or less, 30 or less, or 20 or less, from the viewpoint of easily suppressing a polishing rate for silicon oxide by the polymer P being adsorbed to silicon oxide. The maximum value of the molecular weight of the side chain in the polymer P may be 15 or more.

The specific cationic polymer can include the polymer A. The hydroxyl group in the polymer A is bonded directly to the carbon atom of the main chain. The polymer A may have a structure unit having a main chain containing a nitrogen atom and a carbon atom, and may have a plurality of kinds (for example, two kinds) of structure units having a main chain containing a nitrogen atom and a carbon atom, from the viewpoint of easily obtaining a high polishing rate for polysilicon and silicon nitride, and the viewpoint of easily suppressing a polishing rate for silicon oxide.

The polymer A may satisfy at least one of the following characteristics, and may have a structure unit satisfying at least one of the following characteristics (a structure unit having a main chain containing a nitrogen atom and a carbon atom), from the viewpoint of easily obtaining a high polishing rate for polysilicon and silicon nitride, and the viewpoint of easily suppressing a polishing rate for silicon oxide.

The main chain containing a nitrogen atom and a carbon atom may contain a nitrogen atom and an alkylene chain bonded to the nitrogen atom. The hydroxyl group may be bonded to the carbon atom of the alkylene chain. The number of carbon atoms of the alkylene chain is 1 or more, and may be 2 or more or 3 or more. The number of carbon atoms of the alkylene chain may be 6 or less, 5 or less, or 4 or less. The number of carbon atoms of the alkylene chain may be 1 to 6.

The polymer A may contain a nitrogen atom constituting a quaternary ammonium salt. The quaternary ammonium salt may contain a nitrogen atom to which at least one selected from the group consisting of an alkyl group and an aryl group is bonded, and may contain a nitrogen atom to which a methyl group is bonded. The quaternary ammonium salt may contain a nitrogen atom to which two alkyl groups are bonded, and may contain a nitrogen atom to which two methyl groups are bonded. The quaternary ammonium salt may contain an ammonium cation and a chloride ion.

The polymer A may contain a nitrogen atom constituting an acid addition salt, and may contain a nitrogen atom constituting a hydrochloride.

In the polymer A, the nitrogen atom may or may not be adjacent to the carbon atom to which the hydroxyl group is bonded. The polymer A may have a hydrocarbon group intervening between the nitrogen atom and the carbon atom to which the hydroxyl group is bonded and may have a hydrocarbon group with one carbon atom (for example, a methylene

group) intervening between the nitrogen atom and the carbon atom to which the hydroxyl group is bonded, from the viewpoint of easily obtaining a high polishing rate for polysilicon and silicon nitride, and the viewpoint of easily suppressing a polishing rate for silicon oxide. The polymer A may have a structure unit having a hydrocarbon group intervening between the nitrogen atom and the carbon atom to which the hydroxyl group is bonded and may have a structure unit having a hydrocarbon group with one carbon atom (for example, a methylene group) intervening between the nitrogen atom and the carbon atom to which the hydroxyl group is bonded, as the structure unit having a main chain containing a nitrogen atom and a carbon atom, from the viewpoint of easily obtaining a high polishing rate for polysilicon and silicon nitride, and the viewpoint of easily suppressing a polishing rate for silicon oxide.

The polymer A may include a reaction product (for example, a condensate) of a raw material containing at least dimethylamine and epichlorohydrin and may include a reaction product (for example, a condensate) of a raw material containing at least dimethylamine, ammonia, and epichlorohydrin, from the viewpoint of easily obtaining a high polishing rate for polysilicon and silicon nitride, and the viewpoint of easily suppressing a polishing rate for silicon oxide. The raw material providing the reaction product may contain a compound other than dimethylamine, ammonia, and epichlorohydrin. The polymer A may include a compound having a structure represented by the formula below from the viewpoint of easily obtaining a high polishing rate for polysilicon and silicon nitride and the viewpoint of easily suppressing a polishing rate for silicon oxide. The polymer A may include at least one selected from the group consisting of dimethylamine/epichlorohydrin condensate (polycondensate) and dimethylamine/ammonia/epichlorohydrin condensate (polycondensate), from the viewpoint of easily obtaining a high polishing rate for polysilicon and silicon nitride and the viewpoint of easily suppressing a polishing rate for silicon oxide. The CMP polishing liquid for use in the method of the present embodiment may not contain a reaction product (for example, a condensate) of a raw material containing dimethylamine, epichlorohydrin, and ethylenediamine as the polymer A.

[Chemical Formula 1]

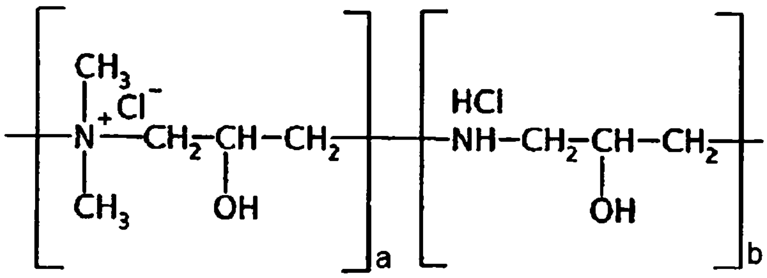

[In the formula, "a" represents an integer of 1 or more, and "b" represents an integer of 0 or more (for example, 1 or more).]

The molecular weight (for example, weight average molecular weight) of the polymer A may be in the following range from the viewpoint of easily obtaining a high polishing rate for polysilicon and silicon nitride and the viewpoint of easily suppressing a polishing rate for silicon oxide. The molecular weight of the polymer A may be 5000 or more, 7000 or more, 8000 or more, 10000 or more, 15000 or more, more than 15000, 30000 or more, 50000 or more, 60000 or more, 80000 or more, 100000 or more, 200000 or more, 300000 or more, 400000 or more, 450000 or more, 500000 or more, 600000 or more, 800000 or more, 1000000 or more, or 1200000 or more. The molecular weight of the polymer A may be 2000000 or less, 1500000 or less, 1300000 or less, 1200000 or less, 1000000 or less, 800000 or less, 600000 or less, 500000 or less, 450000 or less, 400000 or less, 300000 or less, 200000 or less, 100000 or less, 60000 or less, 50000 or less, 30000 or less, 15000 or less, less than 15000, 10000 or less, or 8000 or less. From these viewpoints, the molecular weight of the polymer A may be 5000 to 2000000, 5000 to 1500000, 10000 to 2000000, 10000 to 1000000, 50000 to 500000, or 100000 to 500000. The molecular weight (for example, weight average molecular weight) of the polymer A can be measured by the method described in Examples.

In a case where the specific cationic polymer includes the polymer A, the content of the polymer A in the cationic polymer or the content of the polymer A in the specific cationic polymer may be 50% by mass or more, 70% by mass or more, 90% by mass or more, 95% by mass or more, 97% by mass or more, 99% by mass or more, or substantially 100% by mass (an embodiment in which the cationic polymer or the specific cationic polymer is substantially composed of the polymer A), on the basis of the whole of the cationic polymer (the whole of the cationic polymer contained in the CMP polishing liquid) or the whole of the specific cationic polymer (the whole of the specific cationic polymer contained in the CMP polishing liquid), from the viewpoint of easily obtaining a high polishing rate for polysilicon and silicon nitride and the viewpoint of easily suppressing a polishing rate for silicon oxide.

The content of the polymer A may be in the following range with respect to 100 parts by mass of the CMP polishing liquid. The content of the polymer A may be 0.00001 parts by mass or more, 0.00005 parts by mass or more, 0.0001 parts

by mass or more, 0.0002 parts by mass or more, 0.0003 parts by mass or more, 0.0005 parts by mass or more, 0.0008 parts by mass or more, 0.001 parts by mass or more, 0.002 parts by mass or more, 0.0025 parts by mass or more, 0.003 parts by mass or more, 0.004 parts by mass or more, 0.005 parts by mass or more, 0.008 parts by mass or more, 0.01 parts by mass or more, 0.012 parts by mass or more, or 0.015 parts by mass or more, from the viewpoint of easily obtaining a high polishing rate for polysilicon and silicon nitride and the viewpoint of easily suppressing a polishing rate for silicon oxide. The content of the polymer A may be 0.02 parts by mass or more, 0.025 parts by mass or more, 0.03 parts by mass or more, 0.04 parts by mass or more, 0.05 parts by mass or more, 0.08 parts by mass or more, or 0.1 parts by mass or more, from the viewpoint of easily suppressing a polishing rate for silicon oxide. The content of the polymer A may be 10 parts by mass or less, 5 parts by mass or less, 2.5 parts by mass or less, less than 2.5 parts by mass, 2 parts by mass or less, 1 part by mass or less, 0.5 parts by mass or less, 0.1 parts by mass or less, 0.08 parts by mass or less, or 0.05 parts by mass or less, from the viewpoint of easily obtaining a high polishing rate for polysilicon and silicon nitride and the viewpoint of easily suppressing a polishing rate for silicon oxide. The content of the polymer A may be 0.04 parts by mass or less, 0.03 parts by mass or less, 0.025 parts by mass or less, 0.02 parts by mass or less, or 0.015 parts by mass or less, from the viewpoint of easily obtaining a high polishing rate for polysilicon and silicon nitride. The content of the polymer A may be 0.012 parts by mass or less, 0.01 parts by mass or less, 0.008 parts by mass or less, or 0.005 parts by mass or less, from the viewpoint of easily obtaining a high polishing rate for silicon nitride. The content of the polymer A may be 0.004 parts by mass or less, 0.003 parts by mass or less, or 0.0025 parts by mass or less. From these viewpoints, the content of the polymer A may be 0.00001 to 10 parts by mass, 0.0001 to 1 part by mass, 0.0025 to 0.1 parts by mass, or 0.001 to 0.1 parts by mass.

A ratio A of the content of the abrasive grains with respect to the content of the polymer A may be in the following range. The ratio A may be 0.1 or more, 0.5 or more, 1 or more, more than 1, 2 or more, 3 or more, 5 or more, 8 or more, or 10 or more, from the viewpoint of easily obtaining a high polishing rate for polysilicon and silicon nitride and the viewpoint of easily suppressing a polishing rate for silicon oxide. The ratio A may be 15 or more, 20 or more, 25 or more, 30 or more, or 33 or more, from the viewpoint of easily obtaining a high polishing rate for polysilicon and silicon nitride. The ratio A may be 40 or more, 50 or more, 60 or more, 62.5 or more, 67 or more, 80 or more, or 100 or more, from the viewpoint of easily obtaining a high polishing rate for silicon nitride. The ratio A may be 120 or more, 150 or more, 167 or more, 200 or more, 300 or more, 400 or more, or 500 or more. The ratio A may be 1000 or less, 800 or less, 500 or less, 400 or less, 300 or less, 200 or less, 167 or less, 150 or less, 120 or less, 100 or less, 80 or less, 67 or less, 62.5 or less, 60 or less, 50 or less, 40 or less, or 33 or less, from the viewpoint of easily obtaining a high polishing rate for polysilicon and silicon nitride and the viewpoint of easily suppressing a polishing rate for silicon oxide. The ratio A may be 30 or less, 25 or less, 20 or less, 15 or less, 10 or less, 8 or less, or 5 or less, from the viewpoint of easily suppressing a polishing rate for silicon oxide. From these viewpoints, the ratio A may be 0. 1 to 1000, 1 to 500, or 5 to 100.

The specific cationic polymer can include the polymer B. The polymer B is an allylamine polymer, and is a polymer having an allylamine compound (a compound having an allyl group and an amino group) as a monomer unit (a polymer having a structure unit derived from an allylamine compound). The polymer B may include a polymer having a diallyldialkylammonium salt as a monomer unit from the viewpoint of easily obtaining a high polishing rate for polysilicon and silicon nitride and the viewpoint of easily suppressing a polishing rate for silicon oxide.

The polymer B has at least one selected from the group consisting of a structure unit represented by General Formula (I) below, a structure unit represented by General Formula (II) below, a structure unit represented by General Formula (III) below, a structure unit represented by General Formula (IV) below, and a structure unit represented by General Formula (V) below, from the viewpoint of easily obtaining a high polishing rate for polysilicon and silicon nitride and the viewpoint of easily suppressing a polishing rate for silicon oxide. As the structure unit contained in the polymer B, the structure units that are represented by General Formulae (I) to (V) may be a single structure unit, and may be two or more structure units.

[Chemical Formula 2]

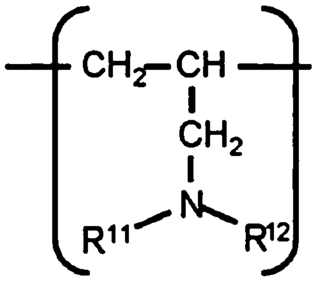

(I)

[In the formula, $R^{11}$ and $R^{12}$ each independently represent a hydrogen atom, an alkyl group, or an aralkyl group, and an amino group may form an acid addition salt.]

[Chemical Formula 3]

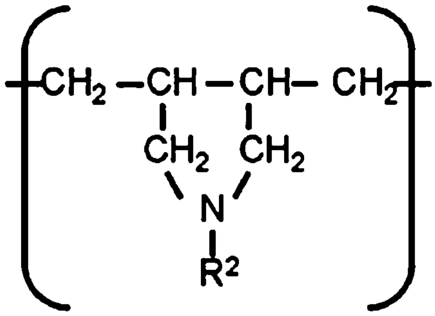

(II)

[In the formula, $R^2$ represents a hydrogen atom, an alkyl group, or an aralkyl group, and a nitrogen-containing ring may form an acid addition salt.]

[Chemical Formula 4]

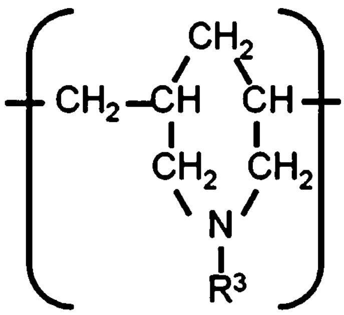

(III)

[In the formula, $R^3$ represents a hydrogen atom, an alkyl group, or an aralkyl group, and a nitrogen-containing ring may form an acid addition salt.]

[Chemical Formula 5]

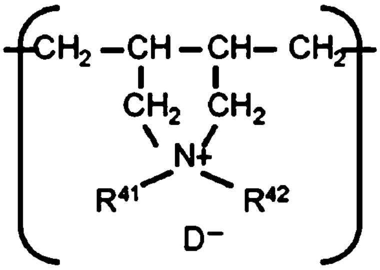

(IV)

[In the formula, $R^{41}$ and $R^{42}$ each independently represent a hydrogen atom, an alkyl group, or an aralkyl group, and $D^-$ represents a monovalent anion.]

[Chemical Formula 6]

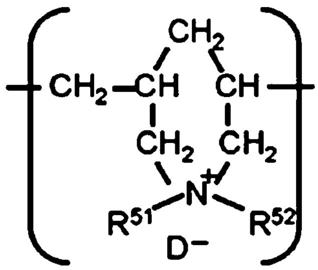

(V)

[In the formula, $R^{51}$ and $R^{52}$ each independently represent a hydrogen atom, an alkyl group, or an aralkyl group, and $D^-$ represents a monovalent anion.]

The alkyl groups corresponding to $R^{11}$, $R^{12}$, $R^2$, and $R^3$ in General Formulae (I), (II), and (III) may be any of a linear form, a branched form, and a cyclic form. Examples of the alkyl groups corresponding to $R^{11}$, $R^{12}$, $R^2$, and $R^3$ include a methyl group, an ethyl group, an n-propyl group, an isopropyl group, an n-butyl group, an iso-butyl group, a tert-butyl group, a cyclohexyl group, and hydroxyl group adducts thereof (a 3-hydroxypropyl group and the like).

The "aralkyl group" refers to a group in which one of the hydrogen atoms in the alkyl group is substituted with an aryl group. The alkyl group constituting the aralkyl groups corresponding to $R^{11}$, $R^{12}$, $R^2$, and $R^3$ in General Formulae (I), (II), and (III) may be any of a linear form, a branched form, and a cyclic form. Examples of the aralkyl groups include a benzyl group, a phenethyl group, a phenylpropyl group, a phenylbutyl group, a phenylhexyl group, and hydroxyl group adducts thereof.

The amino group in General Formula (I) and the nitrogen-containing rings in General Formulae (II) and (III) may form an acid addition salt. Examples of the acid addition salts include hydrochloride, hydrobromide, acetate, sulfate, nitrate, sulfite, phosphate, amide sulfate, and methanesulfonate.

The polymer B may have the structure unit represented by General Formula (I) and may have a structure unit in which $R^{11}$ and $R^{12}$ in General Formula (I) are a hydrogen atom, from the viewpoint of easily obtaining a high polishing rate for polysilicon and silicon nitride and the viewpoint of easily suppressing a polishing rate for silicon oxide.

The alkyl groups corresponding to $R^{41}$, $R^{42}$, $R^{51}$, and $R^{52}$ in General Formulae (IV) and (V) may be any of a linear form, a branched form, and a cyclic form. Examples of the alkyl groups corresponding to $R^{41}$, $R^{42}$, $R^{51}$, and $R^{52}$ include a methyl group, an ethyl group, an n-propyl group, an isopropyl group, an n-butyl group, an iso-butyl group, a tert-butyl group, a cyclohexyl group, and hydroxyl group adducts thereof (a 3-hydroxypropyl group and the like). The number of carbon atoms of the alkyl group of at least one selected from the group consisting of $R^{41}$, $R^{42}$, $R^{51}$, and $R^{52}$ may be 1 to 10, 1 to 7, 1 to 4, 1 to 3, or 1 to 2 or less, from the viewpoint of easily obtaining a high polishing rate for polysilicon and silicon nitride and the viewpoint of easily suppressing a polishing rate for silicon oxide.

The alkyl group constituting the aralkyl groups corresponding to $R^{41}$, $R^{42}$, $R^{51}$, and $R^{52}$ in General Formulae (IV) and (V) may be any of a linear form, a branched form, and a cyclic form. Examples of the aralkyl groups corresponding to $R^{41}$, $R^{42}$, $R^{51}$, and $R^{52}$ include a benzyl group, a phenethyl group, a phenylpropyl group, a phenylbutyl group, and hydroxyl

group adducts thereof.

The polymer B may have the structure unit represented by General Formula (IV) and may have a structure unit in which $R^{41}$ and $R^{42}$ in General Formula (IV) are a methyl group, from the viewpoint of easily obtaining a high polishing rate for polysilicon and silicon nitride and the viewpoint of easily suppressing a polishing rate for silicon oxide.

Examples of $D^-$ in General Formulae (IV) and (V) include halogen ions such as $Cl^-$, $Br^-$, and $I^-$; and alkyl sulfate ions such as a methyl sulfate ion, an ethyl sulfate ion, and a dimethyl sulfate ion.

Examples of a partial structure represented by General Formula (IVa) below in General Formula (IV) and a partial structure represented by General Formula (Va) below in General Formula (V) include N,N-dialkylammonium salts and N-alkyl-N-benzyl ammonium salts. Examples of the N,N-dialkylammonium salts include N,N-dialkylammonium halides and N,N-dialkylammonium alkyl sulfates. Examples of the N,N-dialkylammonium halides include N,N-dimethylammonium halides, N,N-diethylammonium halides, N,N-dipropylammonium halides, and N,N-dibutylammonium halides. Examples of the N,N-dialkylammonium alkyl sulfates include N,N-dimethylammonium methyl sulfate and N,N-methylethylammonium ethyl sulfate. Examples of the N-alkyl-N-benzyl ammonium salts include N-alkyl-N-benzylammonium halides such as N-methyl-N-benzylammonium halide and N-ethyl-N-benzylammonium halide. Examples of the halides of the aforementioned partial structure include chloride, bromide, and iodide. The polymer B may have at least one selected from the group consisting of N,N-dimethylammonium chloride and N,N-methylethylammonium ethyl sulfate, as the aforementioned partial structure, from the viewpoint of easily obtaining a high polishing rate for polysilicon and silicon nitride and the viewpoint of easily suppressing a polishing rate for silicon oxide.

[Chemical Formula 7]

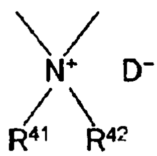

(IVa)

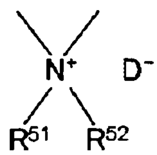

(Va)

The polymer B may be a copolymer of an allylamine compound with a compound other than the allylamine compound. The polymer B may have, for example, a structure obtained by copolymerizing of a monomer which provides the structure unit represented by General Formula (IV) and a monomer other than the allylamine compound.

The polymer B may have a structure unit represented by General Formula (VI) below, and may have the structure unit represented by General Formula (IV) and the structure unit represented by General Formula (VI), from the viewpoint of easily obtaining a high polishing rate for polysilicon and silicon nitride and the viewpoint of easily suppressing a polishing rate for silicon oxide.

[Chemical Formula 8]

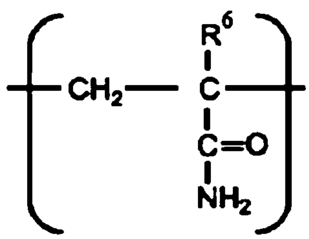

(VI)

[In the formula, $R^6$ represents a hydrogen atom or an alkyl group.]

$R^6$ in General Formula (VI) may be at least one selected from the group consisting of a hydrogen atom and a methyl group and may be a hydrogen atom, from the viewpoint of easily obtaining a high polishing rate for polysilicon and silicon nitride and the viewpoint of easily suppressing a polishing rate for silicon oxide. Examples of monomers which provide the structure unit represented by General Formula (VI) include acrylamide.

The polymer B may include at least one selected from the group consisting of a diallylmethylammonium chloride/acrylamide copolymer and a diallyldimethylammonium chloride/acrylamide copolymer, as the allylamine polymer having the structure unit represented by General Formula (VI), from the viewpoint of easily obtaining a high polishing rate for polysilicon and silicon nitride and the viewpoint of easily suppressing a polishing rate for silicon oxide.

The molecular weight (for example, weight average molecular weight) of the polymer B may be in the following range from the viewpoint of easily obtaining a high polishing rate for polysilicon and silicon nitride and the viewpoint of easily suppressing a polishing rate for silicon oxide. The molecular weight of the polymer B may be 1000 or more, 3000 or more, 5000 or more, 8000 or more, 10000 or more, 30000 or more, 50000 or more, 80000 or more, 100000 or more, 300000 or more, or 500000 or more. The weight average molecular weight of the polymer B may be 2000000 or less, 1500000 or less, 1000000 or less, 800000 or less, 600000 or less, 500000 or less, 300000 or less, 100000 or less, 80000 or less, 50000 or less, 30000 or less, 15000 or less, less than 15000, 10000 or less, or 8000 or less. From these viewpoints, the molecular weight of the polymer B may be 1000 to 2000000, 5000 to 1000000, or 8000 to 1000000. The molecular weight of the polymer B can be measured in the same manner as in the molecular weight of the polymer A.

In a case where the specific cationic polymer includes the polymer B, the content of the polymer B in the cationic polymer or the content of the polymer B in the specific cationic polymer may be 50% by mass or more, 70% by mass or more, 90% by mass or more, 95% by mass or more, 97% by mass or more, 99% by mass or more, or substantially 100% by mass (an embodiment in which the cationic polymer or the specific cationic polymer is substantially composed of the polymer B), on the basis of the whole of the cationic polymer (the whole of the cationic polymer contained in the CMP polishing liquid) or the whole of the specific cationic polymer (the whole of the specific cationic polymer contained in the CMP polishing liquid), from the viewpoint of easily obtaining a high polishing rate for polysilicon and silicon nitride and the viewpoint of easily suppressing a polishing rate for silicon oxide.

The content of the polymer B may be in the following range with respect to 100 parts by mass of the CMP polishing liquid. The content of the polymer B may be 0.00001 parts by mass or more, 0.00005 parts by mass or more, 0.0001 parts by mass or more, 0.0002 parts by mass or more, 0.0003 parts by mass or more, 0.0005 parts by mass or more, 0.0008 parts by mass or more, 0.001 parts by mass or more, 0.002 parts by mass or more, 0.0025 parts by mass or more, 0.003 parts by mass or more, 0.004 parts by mass or more, or 0.005 parts by mass or more, from the viewpoint of easily obtaining a high polishing rate for polysilicon and silicon nitride and the viewpoint of easily suppressing a polishing rate for silicon oxide. The content of the polymer B may be 0.008 parts by mass or more, or 0.01 parts by mass or more, from the viewpoint of easily suppressing a polishing rate for silicon oxide. The content of the polymer B may be 10 parts by mass or less, 5 parts by mass or less, 2.5 parts by mass or less, less than 2.5 parts by mass, 2 parts by mass or less, 1 part by mass or less, 0.5 parts by mass or less, 0.1 parts by mass or less, 0.08 parts by mass or less, 0.05 parts by mass or less, 0.04 parts by mass or less, 0.03 parts by mass or less, 0.025 parts by mass or less, 0.02 parts by mass or less, 0.015 parts by mass or less, 0.012 parts by mass or less, or 0.01 parts by mass or less, from the viewpoint of easily obtaining a high polishing rate for polysilicon and silicon nitride and the viewpoint of easily suppressing a polishing rate for silicon oxide. The content of the polymer B may be 0.008 parts by mass or less, or 0.005 parts by mass or less, from the viewpoint of easily obtaining a high polishing rate for polysilicon and silicon nitride. From these viewpoints, the content of the polymer B may be 0.00001 to 10 parts by mass, 0.0001 to 1 part by mass, 0.001 to 0.01 parts by mass, or 0.005 to 0.01 parts by mass.

A ratio B of the content of the abrasive grains with respect to the content of the polymer B may be in the following range. The ratio B may be 0.1 or more, 0.5 or more, 1 or more, more than 1, 2 or more, 3 or more, 5 or more, 8 or more, 10 or more, 15 or more, 20 or more, 25 or more, 30 or more, 33 or more, 40 or more, or 50 or more, from the viewpoint of easily obtaining a high polishing rate for polysilicon and silicon nitride and the viewpoint of easily suppressing a polishing rate for silicon oxide. The ratio B may be 60 or more, 62.5 or more, 67 or more, 80 or more, or 100 or more, from the viewpoint of easily obtaining a high polishing rate for polysilicon and silicon nitride. The ratio B may be 1000 or less, 800 or less, 500 or less, 400 or less, 300 or less, 200 or less, 167 or less, 150 or less, 120 or less, or 100 or less, from the viewpoint of easily obtaining a high polishing rate for polysilicon and silicon nitride and the viewpoint of easily suppressing a polishing rate for silicon oxide. The ratio B may be 80 or less, 67 or less, 62.5 or less, 60 or less, or 50 or less, from the viewpoint of easily suppressing a polishing rate for silicon oxide. From these viewpoints, the ratio B may be 0.1 to 1000, 10 to 500, or 50 to 100.

The content of the specific cationic polymer (the sum of the content of the polymer A and the content of the polymer B) may be in the following range with respect to 100 parts by mass of the CMP polishing liquid from the viewpoint of easily obtaining a high polishing rate for polysilicon and silicon nitride and the viewpoint of easily suppressing a polishing rate for silicon oxide. The content of the specific cationic polymer may be 0.00001 parts by mass or more, 0.00005 parts by mass or more, 0.0001 parts by mass or more, 0.0002 parts by mass or more, 0.0003 parts by mass or more, 0.0005 parts by mass or more, 0.0008 parts by mass or more, 0.001 parts by mass or more, 0.002 parts by mass or more, 0.0025 parts by mass or more, 0.003 parts by mass or more, 0.004 parts by mass or more, 0.005 parts by mass or more, 0.008 parts by mass or more, 0.01 parts by mass or more, 0.012 parts by mass or more, 0.015 parts by mass or more, 0.02 parts by mass or more, 0.025 parts by mass or more, 0.03 parts by mass or more, 0.05 parts by mass or more, 0.08 parts by mass or more, or 0.1 parts by mass or more. The content of the specific cationic polymer may be 10 parts by mass or less, 5 parts by mass or less, 2.5 parts by mass or less, less than 2.5 parts by mass, 2 parts by mass or less, 1 part by mass or less, 0.5 parts by

mass or less, 0.1 parts by mass or less, 0.08 parts by mass or less, 0.05 parts by mass or less, 0.03 parts by mass or less, 0.025 parts by mass or less, 0.02 parts by mass or less, 0.015 parts by mass or less, 0.012 parts by mass or less, 0.01 parts by mass or less, 0.008 parts by mass or less, 0.005 parts by mass or less, 0.004 parts by mass or less, 0.003 parts by mass or less, or 0.0025 parts by mass or less. From these viewpoints, the content of the specific cationic polymer may be 0.00001 to 10 parts by mass, 0.0001 to 1 part by mass, 0.001 to 0.01 parts by mass, 0.005 to 0.01 parts by mass, 0.0025 to 0.1 parts by mass, or 0.001 to 0.01 parts by mass.

A ratio C of the content of the abrasive grains with respect to the content of the specific cationic polymer (the sum of the content of the polymer A and the content of the polymer B) may be in the following range from the viewpoint of easily obtaining a high polishing rate for polysilicon and silicon nitride and the viewpoint of easily suppressing a polishing rate for silicon oxide. The ratio C may be 0.1 or more, 0.5 or more, 1 or more, more than 1, 2 or more, 3 or more, 5 or more, 8 or more, 10 or more, 15 or more, 20 or more, 25 or more, 30 or more, 33 or more, 40 or more, 50 or more, 60 or more, 62.5 or more, 67 or more, 80 or more, 100 or more, 120 or more, 150 or more, 167 or more, 200 or more, 300 or more, 400 or more, or 500 or more. The ratio C may be 1000 or less, 800 or less, 500 or less, 400 or less, 300 or less, 200 or less, 167 or less, 150 or less, 120 or less, 100 or less, 80 or less, 67 or less, 62.5 or less, 60 or less, 50 or less, 40 or less, 33 or less, 30 or less, 25 or less, 20 or less, 15 or less, 10 or less, 8 or less, or 5 or less. From these viewpoints, the ratio C may be 0.1 to 1000, 1 to 500, 50 to 100, or 5 to 100.

(Water)

The CMP polishing liquid for use in the method of the present embodiment can contain water. Water is not particularly limited, and may be at least one selected from the group consisting of deionized water, ion-exchange water, and ultrapure water.

(Other components)

The CMP polishing liquid for use in the method of the present embodiment may contain other additives (excluding a compound corresponding to the cationic polymer). Examples of the additives include a pH adjusting agent and a pH buffering agent which will be described below; a water-soluble polymer; and a nonionic surfactant.

Examples of the water-soluble polymer include polyacrylic acid-based polymers such as polyacrylic acid, a polyacrylic acid copolymer, polyacrylate, and a polyacrylic acid copolymer salt; polymethacrylic acid-based polymers such as polymethacrylic acid and polymethacrylate; polyacrylamide; polydimethylacrylamide; polysaccharides such as alginic acid, pectinic acid, carboxymethylcellulose, agar, curdlan, dextrin, cyclodextrin, and pullulan; vinyl-based polymers such as polyvinyl alcohol, polyvinylpyrrolidone, and polyacrolein; glycerin-based polymers such as polyglycerin and polyglycerin derivatives; and polyethylene glycol.

Examples of the nonionic surfactant include ether-type surfactants such as polyoxypropylene polyoxyethylene alkyl ether, polyoxyethylene alkyl ether, polyoxyethylene alkylaryl ether, polyoxyethylene polyoxypropylene ether derivatives, polyoxypropylene glyceryl ether, oxyethylene adducts of polyethylene glycol, oxyethylene adducts of methoxypolyethylene glycol, oxyethylene adducts of acethylene-based diols; ester-type surfactants such as sorbitan fatty acid ester and glycerol borate fatty acid ester; amino ether-type surfactants such as polyoxyethylene alkylamine; ether ester-type surfactants such as polyoxyethylene sorbitan fatty acid ester, polyoxyethylene glycerol borate fatty acid ester, and polyoxyethylene alkyl ester; alkanolamide-type surfactants such as fatty acid alkanolamide and polyoxyethylene fatty acid alkanolamide; oxyethylene adducts of acetylene-based diols; polyvinylpyrrolidone; polyacrylamide; polydimethylacrylamide; and polyvinyl alcohol.

In the CMP polishing liquid for use in the method of the present embodiment, the content of guanidine carbonate may be 0.001 parts by mass or less, less than 0.001 parts by mass, or 0.0001 parts by mass or less, with respect to 100 parts by mass of the CMP polishing liquid. The CMP polishing liquid for use in the method of the present embodiment may not contain guanidine carbonate (the content of guanidine carbonate may be substantially 0 parts by mass). The content of hydroxyalkyl cellulose may be 0.005 parts by mass or less, less than 0.005 parts by mass, or 0.001 parts by mass or less, with respect to 100 parts by mass of the CMP polishing liquid. The CMP polishing liquid for use in the method of the present embodiment may not contain hydroxyalkyl cellulose (the content of hydroxyalkyl cellulose may be substantially 0 parts by mass). The content of an oxidant may be 0.01 parts by mass or less, 0.001 parts by mass or less, or 0.0001 parts by mass or less, with respect to 100 parts by mass of the CMP polishing liquid. The CMP polishing liquid for use in the method of the present embodiment may not contain an oxidant (the content of the oxidant may be substantially 0 parts by mass). The content of a 4-pyrone-based compound may be 0.01 parts by mass or less, less than 0.01 parts by mass, 0.001 parts by mass or less, less than 0.001 parts by mass, or 0.0001 parts by mass or less, with respect to 100 parts by mass of the CMP polishing liquid. The CMP polishing liquid for use in the method of the present embodiment may not contain a 4-pyrone-based compound (the content of the 4-pyrone-based compound may be substantially 0 parts by mass). The content of an aromatic polyoxyalkylene compound may be 0.1 parts by mass or less, 0.05 parts by mass or less, less than 0.005 parts by

mass, 0.001 parts by mass or less, or 0.0001 parts by mass or less, with respect to 100 parts by mass of the CMP polishing liquid. The CMP polishing liquid for use in the method of the present embodiment may not contain an aromatic polyoxyalkylene compound (the content of the aromatic polyoxyalkylene compound may be substantially 0 parts by mass).

(pH)

The pH of the CMP polishing liquid for use in the method of the present embodiment may be in the following range. The pH may be 10.0 or less, 9.5 or less, 9.0 or less, 8.0 or less, less than 8.0, 7.0 or less, less than 7.0, 6.5 or less, 6.0 or less, less than 6.0, 5.0 or less, less than 5.0, or 4.8 or less, from the viewpoint of easily obtaining a high polishing rate for polysilicon and silicon nitride and the viewpoint of easily suppressing a polishing rate for silicon oxide. The pH may be 1.0 or more, 1.5 or more, 2.0 or more, 2.2 or more, 2.4 or more, 2.5 or more, 3.0 or more, more than 3.0, 3.2 or more, 3.5 or more, 3.8 or more, 4.0 or more, more than 4.0, 4.2 or more, 4.5 or more, or 4.8 or more, from the viewpoint of easily obtaining a high polishing rate for polysilicon and silicon nitride. From these viewpoints, the pH may be 1.0 to 10.0, 1.0 to 8.0, 3.0 to 7.0, 3.5 to 6.0, or 2.0 to 5.0. The pH is defined as the pH at a liquid temperature of 25°C.

The pH of the CMP polishing liquid for use in the method of the present embodiment can be measured by a pH meter (for example, Model No. F-51 manufactured by HORIBA, Ltd.). For example, after performing 3-point calibration of the pH meter using a phthalate pH buffer solution (pH: 4.01), a neutral phosphate pH buffer solution (pH: 6.86), and a borate pH buffer solution (pH: 9.18) as standard buffer solutions, an electrode of the pH meter is placed in the CMP polishing liquid, and the pH upon stabilization after an elapse of 3 minutes or longer is measured. At this time, both the liquid temperatures of the standard buffer solutions and the CMP polishing liquid are set to 25°C.

The pH of the CMP polishing liquid may change depending on the type of compounds used as additives. Therefore, the CMP polishing liquid may contain a pH adjusting agent (excluding a compound corresponding to the specific cationic polymer) in order to adjust the pH in the above range. Examples of the pH adjusting agent include an acid component and a base component. Examples of the acid component include organic acids (excluding compounds corresponding to amino acids) such as propionic acid and acetic acid; inorganic acids such as nitric acid, sulfuric acid, hydrochloric acid, phosphoric acid, and boric acid; amino acids such as glycine; heterocyclic amine; and alkanolamine. Examples of the base component include ammonia, sodium hydroxide, potassium hydroxide, calcium hydroxide, and tetramethylammonium hydroxide (TMAH). The CMP polishing liquid for use in the method of the present embodiment may contain an acid component and may contain an organic acid. The CMP polishing liquid may contain a pH buffering agent in order to stabilize pH. A buffering agent may be added as a buffer solution (a liquid containing a buffering agent). Examples of the buffer solution include an acetate buffer solution and a phthalate buffer solution. A CMP polishing liquid prepared without using a pH adjusting agent or a pH buffering agent may be used directly for CMP.

The CMP polishing liquid for use in the method of the present embodiment may be stored as a one-pack type polishing liquid containing at least abrasive grains and a cationic polymer, and may be stored as a multi-pack type (for example, two-pack type) polishing liquid set (CMP polishing liquid set) containing constituent components of the CMP polishing liquid divided into a slurry (first liquid) and an additive liquid (second liquid) such that the slurry and additive liquid are mixed to form the CMP polishing liquid. The slurry contains, for example, at least abrasive grains and water. The additive liquid contains, for example, at least a cationic polymer and water.

In the aforementioned polishing liquid set, the slurry and the additive liquid are mixed immediately before polishing or during polishing to prepare the CMP polishing liquid. Furthermore, the one-pack type polishing liquid may be stored as a stock solution for a polishing liquid with a reduced water content and used by dilution with water during the polishing. The multi-pack type polishing liquid set may be stored as a stock solution for a slurry and a stock solution for an additive liquid with a reduced water content, and used by dilution with water during the polishing.

<Polishing method>

A polishing method of the present embodiment includes a polishing step of polishing a material to be polished which contains polysilicon by using the CMP polishing liquid for use in the method of the present embodiment. The polishing step may be a step of polishing a material to be polished of a base substrate having the material to be polished on the surface thereof by using the CMP polishing liquid for use in the method of the present embodiment. The polishing step may be a step of polishing a material to be polished by a polishing member (such as a polishing pad) while supplying the CMP polishing liquid for use in the method of the present embodiment between the material to be polished and the polishing member. The polishing step may be, for example, a step of flattening a base substrate having a material to be polished on the surface thereof by the CMP technique using a CMP polishing liquid in which the content of each component, the pH, or the like are adjusted. The material to be polished may be in a film form (film to be polished) and may be a polysilicon film.

The polishing method of the present embodiment is suitable for polishing the base substrate having a material to be polished on the surface thereof in the production process of a device as described below. Examples of the device

include a discrete semiconductor such as diode, transistor, compound semiconductor, thermistor, varistor, and thyristor; a memory element such as DRAM (dynamic random access memory), SRAM (static random access memory), EPROM (erasable programmable read-only memory), mask ROM (mask read-only memory), EEPROM (electrically erasable programmable read-only memory), and flash memory; a logic circuit element such as a microprocessor, DSP, and ASIC; an integrated circuit element such as a compound semiconductor typified by MMIC (monolithic microwave integrated circuit); a hybrid integrated circuit (hybrid IC), and a photoelectric conversion element such as light emitting diode and charge-coupled element.

The polishing method of the present embodiment is suitable for polishing of a surface of a base substrate having step height (irregularities) on the surface thereof. Examples of the base substrate include logic semiconductor devices and memory semiconductor devices. The material to be polished may be a material to be polished having a step height with the height of 1 μm or more or a material to be polished having a portion with a concave portion or a convex portion in a T-shaped or lattice-shaped fashion when viewed from above. For example, an object to be polished having a material to be polished may be a semiconductor substrate having a memory cell. According to the present embodiment, a material to be polished provided on a surface of a semiconductor device (a DRAM, a flash memory, or the like) including a semiconductor substrate having a memory cell can also be polished at a high polishing rate. According to the present embodiment, a material to be polished provided on a surface of a 3D-NAND flash memory can also be polished at a high polishing rate while securing high flatness. The material to be polished of the base substrate may contain Al, Cu, Ti, TiN, W, Ta, TaN, or the like, in addition to polysilicon.

As the polishing apparatus, for example, an apparatus provided with a holder for holding a base substrate, a polishing platen to which a polishing pad is attached, and a means for supplying a CMP polishing liquid onto the polishing pad is suitable. Examples of the polishing apparatus include a polishing apparatus (Model No.: EPO-111, EPO-222, FREX200, FREX300, or the like) manufactured by EBARA CORPORATION and a polishing apparatus (trade name: Mirra3400, Reflexion, or the like) manufactured by Applied Materials, Inc.

As the polishing pad, common unwoven cloth, a foamed body, an unfoamed body, and the like can be used. As the material of the polishing pad, it is possible to use a resin such as polyurethane, an acrylic resin, polyester, an acrylic-ester copolymer, polytetrafluoroethylene, polypropylene, polyethylene, poly-4-methylpentene, cellulose, cellulose ester, polyamide (for example, Nylon (trade name) and aramid), polyimide, polyimidamide, a polysiloxane copolymer, an oxirane compound, a phenolic resin, polystyrene, polycarbonate, or an epoxy resin. Particularly, from the viewpoint of being further excellent in polishing rate and flatness, the material for the polishing pad may be at least one selected from the group consisting of a foamed polyurethane and a non-foamed polyurethane. The polishing pad may be subjected to grooving so that the CMP polishing liquid is pooled.

Polishing conditions are not particularly limited, but the rotation speed of the polishing platen may be 200 rpm ($min^{-1}$) or less from the viewpoint that the base substrate is not let out, and the pressure (processing load) to be applied to the base substrate may be 100 kPa or less from the viewpoint of easily suppressing scratches on the polished surface. The CMP polishing liquid may be continuously supplied to the polishing pad with a pump or the like during polishing. The amount supplied for this is not limited, but the surface of the polishing pad may be always covered with the CMP polishing liquid.

The base material may be sufficiently washed in running water after the completion of polishing, then dried after removing droplets, which have attached onto the base substrate, with the use of a spin dry or the like.

Polishing in this manner allows irregularities on the surface to be eliminated, and thereby a smooth surface across the entire base substrate can be obtained. By repeating the formation of a material to be polished and the polishing thereof a predetermined number of times, a base substrate having desired number of layers can be produced.

The base substrate obtained in this way can be used as various electronic components and machine components. Specific examples thereof include semiconductor elements; optical glass for a photomask, a lens, or a prism; inorganic conductive films of ITO or the like; optical integrated circuits/optical switching elements/optical waveguides constituted with glass and crystalline materials; optical single crystals such as end faces of optical fibers and scintillators; solid laser single crystals; sapphire substrates for blue laser LEDs; semiconductor single crystals of SiC, GaP, GaAs, or the like; glass substrates for magnetic discs; and magnetic heads.

A method of producing a component of the present embodiment includes an individually dividing step of dividing a base substrate polished by the polishing method of the present embodiment into individual pieces. The base substrate includes polysilicon. Examples of the base substrate include a wafer (for example, a semiconductor wafer). The individually dividing step may be, for example, a step of dicing a wafer (for example, a semiconductor wafer) polished by the polishing method of the present embodiment to obtain chips (for example, semiconductor chips). The method of producing a component of the present embodiment may include a step of polishing a base substrate by the polishing method of the present embodiment before the individually dividing step. A component of the present embodiment may be, for example, a chip (for example, a semiconductor chip). The component of the present embodiment is a component obtained by the method of producing a component of the present embodiment. An electronic device of the present embodiment includes the component of the present embodiment.

## Examples

Hereinafter, the present invention will be further specifically described by means of Examples; however, the present invention is not limited to these Examples. For example, the type of materials for the CMP polishing liquid and the blending ratio thereof may be types and ratios other than the types and ratios described in the present Examples, and the composition and the structure of the object to be polished may also be compositions and structures other than the compositions and the structures described in the present Examples.

<Preparation of abrasive grains>

(Cerium oxide particles)

40 kg of cerium carbonate hydrate was placed in an alumina container and fired at 830°C for 2 hours in air to obtain 20 kg of yellowish-white powder. The phase identification of this powder was performed by an X-ray diffraction method, and it was confirmed that this powder contained polycrystalline cerium oxide. The particle diameter of the powder obtained by firing was observed with a SEM and was found to be 20 to 100 μm. Next, 20 kg of the cerium oxide powder was dry pulverized using a jet mill. The cerium oxide powder after the pulverization was observed with a SEM, and was found to include particles containing polycrystalline cerium oxide having a crystal boundary. Furthermore, the specific surface area of the cerium oxide powder was 9.4 $m^2/g$. The measurement of the specific surface area was performed by the BET method.

15 kg of the aforementioned cerium oxide powder and 84.7 kg of deionized water were placed in a container and mixed. Further, 0.3 kg of 1 N acetic acid aqueous solution was added and stirred for 10 minutes to thereby obtain a cerium oxide mixed liquid. This cerium oxide mixed liquid was send to another container over 30 minutes. Meanwhile, in the sending pipe, the cerium oxide mixed liquid was irradiated with ultrasonic wave at an ultrasonic wave frequency of 400 kHz.

500 g of the cerium oxide mixed liquid was collected in each of four 500 mL beakers and centrifugal separation was performed. The centrifugal separation was carried out for 2 minutes under the conditions that the centrifugal force exerted to the outer circumference was 500 G. The cerium oxide particles (ceria particles, abrasive grains) precipitated at the bottom of the beaker was recovered and the supernatant was taken. The average particle diameter of the cerium oxide particles in the dispersion liquid with a content of the cerium oxide particles of 5% by mass was measured using a laser diffraction/scattering type particle size distribution analyzer (trade name: LA-920 manufactured by HORIBA, Ltd.); as a result, the average particle diameter was 90 nm.

(Silicon oxide particles)

As the silicon oxide particles (silica particles, abrasive grains), trade name "PL-3" manufactured by FUSO CHEMICAL CO., LTD. was prepared. The average particle diameter of the silicon oxide particles in the dispersion liquid with a content of the silicon oxide particles of 5% by mass was measured using a laser diffraction/scattering type particle size distribution analyzer (trade name: LA-920 manufactured by HORIBA, Ltd.); as a result, the average particle diameter was 70 nm.

<Preparation of CMP polishing liquid>

CMP polishing liquids of each Example and Comparative Examples 2 to 4 were obtained by mixing abrasive grains (the aforementioned cerium oxide particles or silicon oxide particles) and a cationic polymer described in Tables 1 to 4 with deionized water. A CMP polishing liquid of Comparative Example 1 was obtained by mixing the aforementioned cerium oxide particles with deionized water. The content of each of the abrasive grains and the cationic polymer (basis;: the total amount of the CMP polishing liquid) is shown in Tables 1 to 4. In the case of supplying the cationic polymer by using a polymer aqueous solution, the content of the cationic polymer was calculated on the basis of the mass of the polymer in the polymer aqueous solution. As the cationic polymer, the following compounds were used.

(Cationic polymer)

[Specific cationic polymer]

A1: Dimethylamine/ammonia/epichlorohydrin polycondensate (manufactured by SENKA corporation, trade name: UNISENCE KHE100L, weight average molecular weight: 7056 (measured value))

A2: Dimethylamine/ammonia/epichlorohydrin polycondensate (manufactured by SENKA corporation, trade name: UNISENCE KHE102L, weight average molecular weight: 53336 (measured value))
A3: Dimethylamine/ammonia/epichlorohydrin polycondensate (manufactured by SENKA corporation, trade name: UNISENCE KHE105L, weight average molecular weight: 479796 (measured value))
A4: Dimethylamine/ammonia/epichlorohydrin polycondensate (manufactured by SENKA corporation, trade name: UNISENCE KHE1000L, weight average molecular weight: 1296145 (measured value))
A5: Dimethylamine/epichlorohydrin polycondensate (manufactured by SENKA corporation, trade name: UNISENCE KHE104L)
B1: Diallyldimethylammonium chloride polycondensate (manufactured SENKA corporation, trade name: UNISENCE FPA1002L, polymer having the structure unit represented by aforementioned General Formula (IV))
B2: Diallyldimethylammonium chloride/acrylamide copolymer (manufactured by NITTOBO MEDICAL CO., LTD., trade name: PAS-J-81, polymer having the structure unit represented by aforementioned General Formula (IV) and the structure unit represented by aforementioned General Formula (VI))
B3: Allylamine polymer (manufactured by NITTOBO MEDICAL CO., LTD., trade name: PAA-08, polymer having the structure unit represented by aforementioned General Formula (I))

[Cationic polymer not corresponding to specific cationic polymer]

X1: Trimethylaminoethyl methacrylate methylsulfate polymer (manufactured by SENKA corporation, trade name: UNISENCE FPV1000L)
X2: Polyalkylene glycol-modified styrene-maleic acid copolymer (manufactured by Kyoeisha Chemical Co., Ltd., trade name: FLOWLEN GW-1500)
X3: Polyoxyethylene polyoxypropylene glyceryl ether (manufactured by AOKI OIL INDUSTRIAL Co., Ltd., trade name: GEP-2500, EO/PO = 30/70)

The measured values of weight average molecular weights of the aforementioned specific cationic polymers A1 to A4 were converted from the calibration curve using a standard polystyrene by gel permeation chromatography (GPC) under the following conditions. The calibration curve was approximated based on a tertiary expression by using standard polyethylene oxide (manufactured by Tosoh Corporation, SE-2, SE-5, SE-30, and SE-150), pullulan (manufactured by Precision System Science Co., Ltd., pss-dpul 2.5 m), and polyethylene glycol (manufactured by FUJIFILM Wako Pure Chemical Corporation, PEG400, PEG1000, PEG3000, and PEG6000).

Pump: trade name "LC-20AD" manufactured by SHIMADZU CORPORATION
Detector: trade name "RID-10A" manufactured by SHIMADZU CORPORATION
Column oven: trade name "CTO-20AC" manufactured by SHIMADZU CORPORATION
Column: two columns of trade name "TSKGel G6000PW$_{XL}$-CP" manufactured by Tosoh Corporation were connected in series
Column size: 7.8 mm I.D × 300 mm
Eluent: 0.1 M sodium nitrate aqueous solution
Sample concentration: 4 mg/2 mL (in terms of N.V.)
Injection amount: 100 μL
Flow rate: 1.0 mL/min
Measurement temperature: 25°C

The average particle diameter of the abrasive grains in the CMP polishing liquid was measured using a laser diffraction/scattering type particle size distribution analyzer (trade name: LA-920 manufactured by HORIBA, Ltd.); as a result, the average particle diameter of the cerium oxide particles was 90 nm in all cases, and the average particle diameter of the silicon oxide particles was 70 nm.
The pH of the CMP polishing liquid was measured under the following conditions. Measurement results are shown in Tables 1 to 4.

Measurement temperature: 25°C
Measurement apparatus: Model No. F-51 manufactured by HORIBA, Ltd.
Measurement method: After performing 3-point calibration using a standard buffer solution (phthalate pH buffer solution, pH: 4.01 (25°C); neutral phosphate pH buffer solution, pH: 6.86 (25°C); borate pH buffer solution, pH: 9.18), an electrode was placed in the CMP polishing liquid, and the pH upon stabilization after an elapse of 3 minutes or

longer was measured by the aforementioned measurement apparatus.

<Polishing characteristic evaluation>

A blanket wafer having a film to be polished (a polysilicon film, a silicon nitride film, or a silicon oxide film) on the surface thereof was polished using each polishing liquid for CMP mentioned above under the following polishing conditions. As the blanket wafer, a wafer having a polysilicon film with a film thickness of 200 nm disposed on a silicon substrate having a diameter of 300 mm, a wafer having a silicon nitride film with a film thickness of 300 nm disposed on a silicon substrate having a diameter of 300 mm, and a wafer having a silicon oxide film (silicon dioxide film) with a film thickness of 1000 nm disposed on a silicon substrate having a diameter of 300 mm were used. The polishing of the polysilicon film using each polishing liquid for CMP mentioned above was performed after the polysilicon film was polished using an aqueous dispersion of the abrasive grains.

[Polishing conditions]

Polishing apparatus: Polishing machine for CMP, Reflexion-LK (manufactured by Applied Materials, Inc.)
Polishing pad: Porous polyurethane pad IC-1010 (manufactured by DuPont)
Polishing pressure (load): 21 kPa (3.0 psi)
Number of revolutions of platen: 93 rpm
Number of revolutions of head: 87 rpm
Amount of CMP polishing liquid to be supplied: 125 mL/min
Polishing time: 15 seconds (polysilicon), 15 seconds (silicon nitride), 30 seconds (silicon oxide)

The film thicknesses of films to be polished (the polysilicon film, the silicon nitride film, and the silicon oxide film) before and after polishing were measured using a light interference type film thickness measuring apparatus (device name: NOVA i500) manufactured by Nova Measuring Instruments and then a change amount in film thickness was calculated. The film thicknesses at 79 points were measured, and a change amount in film thickness was calculated using an average value of the film thickness. The polishing rate for the film to be polished (blanket wafer polishing rate) was calculated by the following formula on the basis of the change amount in film thickness and the polishing time. Furthermore, the polishing rate ratio of polysilicon with respect to silicon oxide and the polishing rate ratio of silicon nitride with respect to silicon oxide were calculated. Results are shown in Tables 1 to 4. It is found that a high polishing rate for polysilicon is obtainable by using the specific cationic polymer.

Polishing rate [Å/min] = (Film thickness [Å] before polishing - Film thickness [Å] after polishing)/Polishing time [min]

[Table 1]

| | | Example | | | | | | | |
|---|---|---|---|---|---|---|---|---|---|
| | | 1 | 2 | 3 | 4 | 5 | 6 | 7 | 8 |
| Abrasive grains | Type | Ceria | Ceria | Ceria | Ceria | Ceria | Ceria | Ceria | Ceria |
| | Content [% by mass] | 0.5 | 0.5 | 0.5 | 0.5 | 0.5 | 0.5 | 2.0 | 0.5 |
| Cationic polymer | Type | A1 | A1 | A1 | A1 | A1 | A1 | A2 | A2 |
| | Content [% by mass] | 0.0025 | 0.0030 | 0.0050 | 0.015 | 0.050 | 0.10 | 0.0050 | 0.010 |
| Abrasive grains/cationic polymer | | 200 | 167 | 100 | 33 | 10 | 5 | 400 | 50 |
| pH of polishing liquid | | 4.8 | 4.8 | 4.8 | 4.8 | 4.8 | 4.8 | 4.8 | 4.8 |
| Polishing rate [Å/min] | Polysilicon (pSi) | 1928 | 2005 | 2260 | 2596 | 2344 | 2237 | 2378 | 2295 |
| | Silicon nitride (SiN) | 1251 | 1225 | 1571 | 1478 | 106 | 66 | 2200 | 1753 |
| | Silicon oxide ($SiO_2$) | 534 | 477 | 99 | 30 | 9 | 9 | 102 | 67 |
| Polishing rate ratio | pSi/$SiO_2$ | 3.6 | 4.2 | 22.8 | 86.5 | 260.4 | 248.6 | 23.3 | 34.3 |
| | SiN/$SiO_2$ | 2.3 | 2.6 | 15.9 | 49.3 | 11.8 | 7.3 | 21.6 | 26.2 |

[Table 2]

| | | Example | | | | | | |
|---|---|---|---|---|---|---|---|---|
| | | 9 | 10 | 11 | 12 | 13 | 14 | 15 |
| Abrasive grains | Type | Ceria | Ceria | Ceria | Ceria | Silica | Ceria | Ceria |
| | Content [% by mass] | 2.0 | 1.0 | 0.5 | 0.5 | 0.5 | 0.5 | 0.5 |
| Cationic polymer | Type | A3 | A3 | A3 | A3 | A3 | A4 | A5 |
| | Content [% by mass] | 0.0040 | 0.015 | 0.020 | 0.025 | 0.010 | 0.0050 | 0.010 |
| Abrasive grains/cationic polymer | | 500 | 67 | 25 | 20 | 50 | 100 | 50 |
| pH of polishing liquid | | 4.8 | 4.8 | 4.8 | 4.8 | 4.8 | 4.8 | 4.8 |
| Polishing rate [Å/min] | Polysilicon (pSi) | 1963 | 2380 | 1675 | 2322 | 1384 | 2153 | 2431 |
| | Silicon nitride (SiN) | 1330 | 1703 | 645 | 153 | 10 | 1626 | 1962 |
| | Silicon oxide ($SiO_2$) | 328 | 18 | 66 | 9 | 18 | 120 | 26 |
| Polishing rate ratio | pSi/$SiO_2$ | 6.0 | 132.2 | 25.4 | 258.0 | 76.9 | 17.9 | 93.5 |
| | SiN/$SiO_2$ | 4.1 | 94.6 | 9.8 | 17.0 | 0.56 | 13.6 | 75.5 |

[Table 3]

| | | Example | | | |
|---|---|---|---|---|---|
| | | 16 | 17 | 18 | 19 |
| Abrasive grains | Type | Ceria | Ceria | Ceria | Ceria |
| | Content [% by mass] | 0.5 | 0.5 | 0.5 | 0.5 |
| Cationic polymer | Type | B1 | B2 | B2 | B3 |
| | Content [% by mass] | 0.0080 | 0.0050 | 0.010 | 0.010 |
| Abrasive grains/cationic polymer | | 62.5 | 100 | 50 | 50 |
| pH of polishing liquid | | 5.0 | 5.0 | 5.1 | 9.2 |
| Polishing rate [Å/min] | Polysilicon (pSi) | 2476 | 2520 | 2469 | 2956 |
| | Silicon nitride (SiN) | 1381 | 1529 | 176 | 33 |
| | Silicon oxide ($SiO_2$) | 79 | 168 | 43 | 28 |
| Polishing rate ratio | pSi/$SiO_2$ | 31.3 | 15.0 | 57.4 | 105.6 |
| | SiN/$SiO_2$ | 17.5 | 9.1 | 4.1 | 1.2 |

[Table 4]

| | | Comparative Example | | | |
|---|---|---|---|---|---|
| | | 1 | 2 | 3 | 4 |
| Abrasive grains | Type | Ceria | Ceria | Ceria | Ceria |
| | Content [% by mass] | 0.5 | 0.5 | 0.5 | 0.5 |
| Cationic polymer | Type | - | X1 | X2 | X3 |
| | Content [% by mass] | - | 0.0080 | 0.010 | 0.0050 |
| Abrasive grains/cationic polymer | | - | 62.5 | 50 | 100 |
| pH of polishing liquid | | 4.8 | 4.8 | 4.8 | 4.8 |
| Polishing rate [Å/min] | Polysilicon (pSi) | 970 | 1189 | 507 | 551 |
| | Silicon nitride (SiN) | 769 | 739 | 235 | 680 |
| | Silicon oxide ($SiO_2$) | 5238 | 5260 | 9282 | 6389 |

(continued)

| | | Comparative Example | | | |
|---|---|---|---|---|---|
| | | 1 | 2 | 3 | 4 |
| Polishing rate ratio | $pSi/SiO_2$ | 0.2 | 0.2 | 0.1 | 0.1 |
| | $SiN/SiO_2$ | 0.15 | 0.14 | 0.03 | 0.11 |

## Claims

1. A polishing method comprising a step of polishing a material to be polished which contains polysilicon by using a CMP polishing liquid for polishing polysilicon, the CMP polishing liquid comprising abrasive grains; and a cationic polymer, wherein

   the cationic polymer includes at least one selected from the group consisting of a polymer A and an allylamine polymer B,
   the polymer A has a main chain containing a nitrogen atom and a carbon atom and a hydroxyl group bonded to the carbon atom, and
   the polymer B has at least one selected from the group consisting of a structure unit represented by General Formula (I) below, a structure unit represented by General Formula (II) below, a structure unit represented by General Formula (III) below, a structure unit represented by General Formula (IV) below, and a structure unit represented by General Formula (V) below:

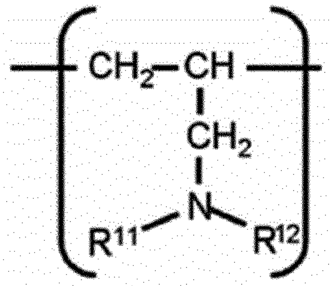

(I)

wherein, in formula (I), $R^{11}$ and $R^{12}$ each independently represent a hydrogen atom, an alkyl group, or an aralkyl group, and the amino group may form an acid addition salt,

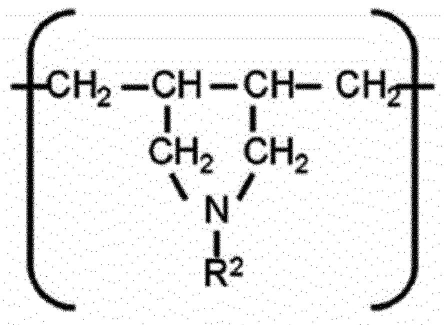

(II)

wherein, in formula (II), $R^2$ represents a hydrogen atom, an alkyl group, or an aralkyl group, and the nitrogen-containing ring may form an acid addition salt,

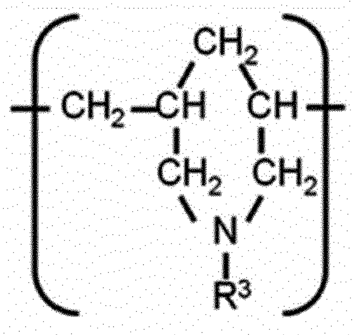

(III)

wherein, in formula (III), $R^3$ represents a hydrogen atom, an alkyl group, or an aralkyl group, and the nitrogen-containing ring may form an acid addition salt,

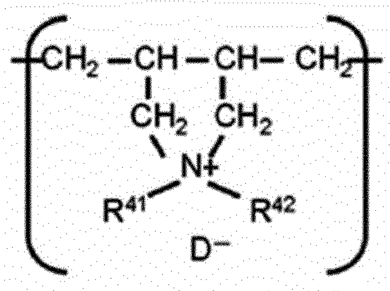

(IV)

wherein, in formula (IV), $R^{41}$ and $R^{42}$ each independently represent a hydrogen atom, an alkyl group, or an aralkyl group, and $D^-$ represents a monovalent anion,

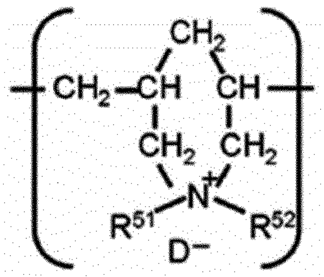

(V)

wherein, in formula (V), $R^{51}$ and $R^{52}$ each independently represent a hydrogen atom, an alkyl group, or an aralkyl group, and $D^-$ represents a monovalent anion.

**2.** The polishing method according to claim 1, wherein the cationic polymer includes the polymer A.

**3.** The polishing method according to claim 2, wherein the polymer A has a plurality of kinds of structure units each having the main chain.

**4.** The polishing method according to claim 2 or 3, wherein the polymer A includes a reaction product of a raw material containing at least dimethylamine and epichlorohydrin.

**5.** The polishing method according to any one of claims 2 to 4, wherein the polymer A includes a reaction product of a raw material containing at least dimethylamine, ammonia, and epichlorohydrin.

6. The polishing method according to any one of claims 2 to 5, wherein a weight average molecular weight of the polymer A is 5000 to 1500000.

7. The polishing method according to any one of claims 2 to 6, wherein a content of the polymer A is 0.001 to 0.1 parts by mass with respect to 100 parts by mass of the CMP polishing liquid.

8. The polishing method according to any one of claims 1 to 7, wherein the cationic polymer includes the allylamine polymer B.

9. The polishing method according to claim 8, wherein the allylamine polymer B includes a polymer having a diallyldialkylammonium salt as a monomer unit.

10. The polishing method according to claim 8 or 9, wherein a content of the polymer B is 0.001 to 0.01 parts by mass with respect to 100 parts by mass of the CMP polishing liquid.

11. The polishing method according to any one of claims 1 to 10, wherein the abrasive grains contain a cerium-based compound.

12. The polishing method according to claim 11, wherein the cerium-based compound includes cerium oxide.

13. The polishing method according to any one of claims 1 to 12, wherein the abrasive grains do not contain a hydroxide.

14. The polishing method according to any one of claims 1 to 13, wherein a content of the abrasive grains is 0.1 to 2 parts by mass with respect to 100 parts by mass of the CMP polishing liquid.

15. The polishing method according to any one of claims 1 to 14, wherein a pH of the CMP polishing liquid is 7.0 or less.

16. The polishing method according to any one of claims 1 to 15, wherein a pH of the CMP polishing liquid is 2.0 to 5.0.

## Patentansprüche

1. Polierverfahren, umfassend einen Schritt zum Polieren eines zu polierenden Materials, das Polysilicium enthält, unter Verwendung einer CMP-Polierflüssigkeit zum Polieren von Polysilicium, wobei die CMP-Polierflüssigkeit Schleifkörner und ein kationisches Polymer umfasst, wobei

das kationische Polymer mindestens eines, ausgewählt aus der Gruppe, bestehend aus einem Polymer A und einem Allylamin-Polymer B, einschließt,
das Polymer A eine Hauptkette aufweist, die ein Stickstoffatom und ein Kohlenstoffatom und eine an das Kohlenstoffatom gebundene Hydroxylgruppe enthält, und
das Polymer B mindestens eine, ausgewählt aus der Gruppe, bestehend aus einer durch die nachstehende allgemeine Formel (I) dargestellten Struktureinheit, einer durch die nachstehende allgemeine Formel (II) dargestellten Struktureinheit, einer durch die nachstehende allgemeine Formel (III) dargestellten Struktureinheit, einer durch die nachstehende allgemeine Formel (IV) dargestellten Struktureinheit und einer durch die nachstehende allgemeine Formel (V) dargestellten Struktureinheit, aufweist:

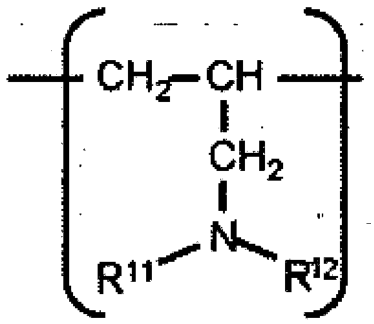

(I)

wobei in Formel (I) $R^{11}$ und $R^{12}$ jeweils unabhängig ein Wasserstoffatom, eine Alkylgruppe oder eine Aralkylgruppe darstellen und die Aminogruppe ein Säureadditionssalz bilden kann,

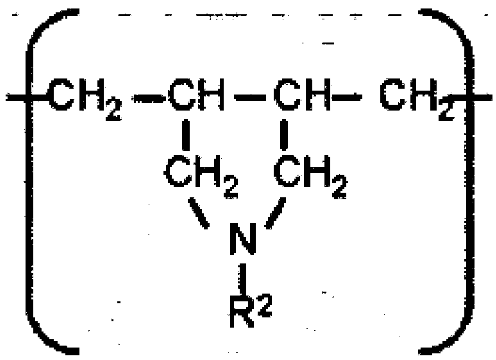

(II)

wobei in Formel (II) $R^2$ ein Wasserstoffatom, eine Alkylgruppe oder eine Aralkylgruppe darstellt und der stickstoffhaltige Ring ein Säureadditionssalz bilden kann,

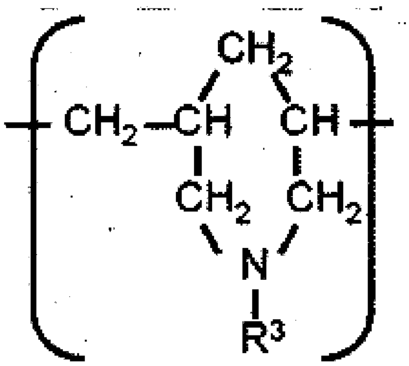

(III)

wobei in Formel (III) $R^3$ ein Wasserstoffatom, eine Alkylgruppe oder eine Aralkylgruppe darstellt und der stickstoffhaltige Ring ein Säureadditionssalz bilden kann,

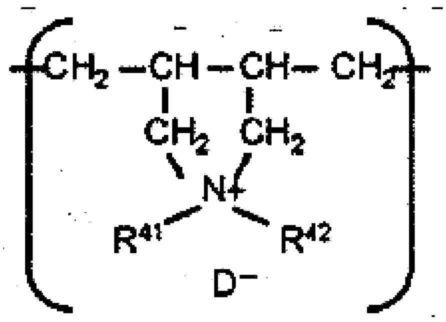

(IV)

wobei in Formel (IV) $R^{41}$ und $R^{42}$ jeweils unabhängig ein Wasserstoffatom, eine Alkylgruppe oder eine Aralkylgruppe darstellen und $D^-$ ein einwertiges Anion darstellt,

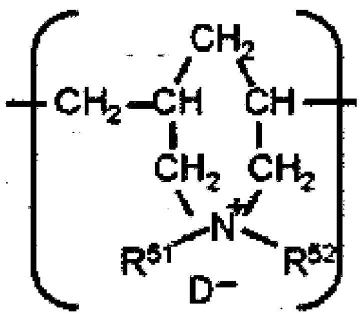

(V)

wobei in Formel (V) $R^{51}$ und $R^{52}$ jeweils unabhängig ein Wasserstoffatom, eine Alkylgruppe oder eine Aralkylgruppe darstellen und $D^-$ ein einwertiges Anion darstellt.

**2.** Polierverfahren gemäß Anspruch 1, wobei das kationische Polymer das Polymer A einschließt.

**3.** Polierverfahren gemäß Anspruch 2, wobei das Polymer A eine Vielzahl von Struktureinheitarten aufweist, die jeweils die Hauptkette aufweisen.

**4.** Polierverfahren gemäß Anspruch 2 oder 3, wobei das Polymer A ein Reaktionsprodukt eines Ausgangsmaterials einschließt, das mindestens Dimethylamin und Epichlorhydrin enthält.

**5.** Polierverfahren gemäß einem der Ansprüche 2 bis 4, wobei das Polymer A ein Reaktionsprodukt eines Ausgangsmaterials einschließt, das mindestens Dimethylamin, Ammoniak und Epichlorhydrin enthält.

**6.** Polierverfahren gemäß einem der Ansprüche 2 bis 5, wobei ein gewichtsmittleres Molekulargewicht des Polymers A 5.000 bis 1.500.000 beträgt.

**7.** Polierverfahren gemäß einem der Ansprüche 2 bis 6, wobei ein Gehalt des Polymers A 0,001 bis 0,1 Masseteile in Bezug auf 100 Masseteile der CMP-Polierflüssigkeit beträgt.

**8.** Polierverfahren gemäß einem der Ansprüche 1 bis 7, wobei das kationische Polymer das Allylamin-Polymer B einschließt.

**9.** Polierverfahren gemäß Anspruch 8, wobei das Allylamin-Polymer B ein Polymer mit einem Diallyldialkylammoniumsalz als Monomereinheit einschließt.

**10.** Polierverfahren gemäß Anspruch 8 oder 9, wobei ein Gehalt des Polymers B 0,001 bis 0,1 Masseteile in Bezug auf 100 Masseteile der CMP-Polierflüssigkeit beträgt.

**11.** Polierverfahren gemäß einem der Ansprüche 1 bis 10, wobei die Schleifkörper eine Verbindung auf Cerbasis enthalten.

**12.** Polierverfahren gemäß Anspruch 11, wobei die Verbindung auf Cerbasis Ceroxid einschließt.

**13.** Polierverfahren gemäß einem der Ansprüche 1 bis 12, wobei die Schleifkörner kein Hydroxid enthalten.

**14.** Polierverfahren gemäß einem der Ansprüche 1 bis 13, wobei ein Gehalt der Schleifkörner 0,1 bis 2 Masseteile in Bezug auf 100 Masseteile der CMP-Polierflüssigkeit beträgt.

**15.** Polierverfahren gemäß einem der Ansprüche 1 bis 14, wobei ein pH-Wert der CMP-Polierflüssigkeit 7,0 oder weniger beträgt.

**16.** Polierverfahren gemäß einem der Ansprüche 1 bis 15, wobei ein pH-Wert der CMP-Polierflüssigkeit 2,0 bis 5,0 beträgt.

## Revendications

**1.** Procédé de polissage comprenant une étape consistant à polir un matériau à polir qui contient un polysilicium par l'utilisation d'un liquide de polissage CMP permettant de polir un polysilicium, le liquide de polissage CMP comprenant des grains abrasifs ; et un polymère cationique, dans lequel

le polymère cationique inclut au moins un sélectionné dans le groupe consistant en un polymère A et un polymère d'allylamine B,
le polymère A présente une chaîne principale contenant un atome d'azote et un atome de carbone et un groupe hydroxyle lié à l'atome de carbone, et
le polymère B présente au moins un sélectionné dans le groupe consistant en une unité de structure représentée par la Formule générale (I) ci-dessous, une unité de structure représentée par la Formule générale (II) ci-dessous, une unité de structure représentée par la Formule générale (III) ci-dessous, une unité de structure représentée par la Formule générale (IV) ci-dessous, et une unité de structure représentée par la Formule générale (V) ci-dessous :

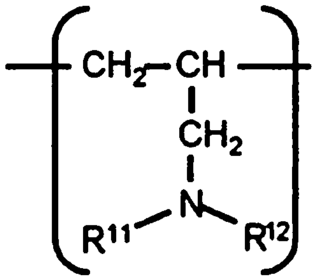

(I)

dans lequel, dans la formule (I), $R^{11}$ et $R^{12}$ représentent chacun indépendamment un atome d'hydrogène, un groupe alkyle, ou un groupe aralkyle, et le groupe amino peut former un sel d'addition d'acide,

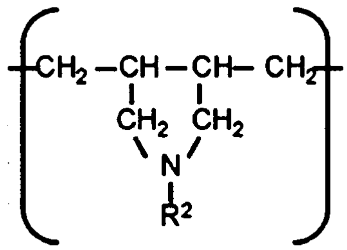

( II )

dans lequel, dans la formule (II), $R^2$ représente un atome d'hydrogène, un groupe alkyle, ou un groupe aralkyle, et le cycle contenant de l'azote peut former un sel d'addition d'acide,

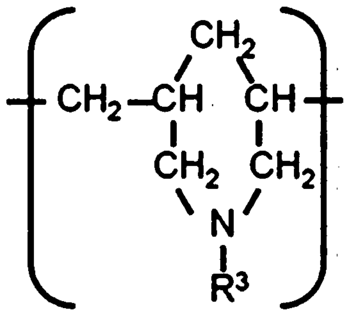

( III )

dans lequel, dans la formule (III), $R^3$ représente un atome d'hydrogène, un groupe alkyle, ou un groupe aralkyle, et le cycle contenant de l'azote peut former un sel d'addition d'acide,

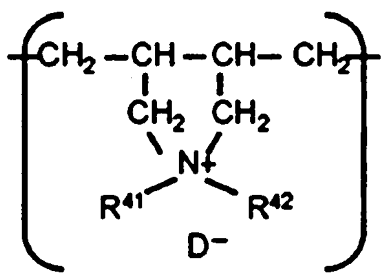

( IV )

dans lequel, dans la formule (IV), $R^{41}$ et $R^{42}$ représentent chacun indépendamment un atome d'hydrogène, un groupe alkyle, ou un groupe aralkyle, et $D^-$ représente un anion monovalent,

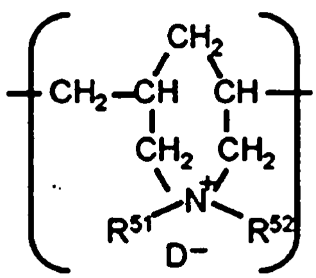

( V )

dans lequel, dans la formule (V), $R^{51}$ et $R^{52}$ représentent chacun indépendamment un atome d'hydrogène, un groupe alkyle, ou un groupe aralkyle, et $D^-$ représente un anion monovalent.

2. Procédé de polissage selon la revendication 1, dans lequel le polymère cationique inclut le polymère A.

3. Procédé de polissage selon la revendication 2, dans lequel le polymère A présente une pluralité de types d'unités de structure présentant chacun la chaîne principale.

4. Procédé de polissage selon la revendication 2 ou 3, dans lequel le polymère A inclut un produit de réaction d'une matière première contenant au moins de la diméthylamine et de l'épichlorohydrine.

5. Procédé de polissage selon l'une quelconque des revendications 2 à 4, dans lequel le polymère A inclut un produit de réaction d'une matière première contenant au moins de la diméthylamine, de l'ammoniaque, et de l'épichlorohydrine.

6. Procédé de polissage selon l'une quelconque des revendications 2 à 5, dans lequel un poids moléculaire moyen en poids du polymère A est 5 000 à 1 500 000.

7. Procédé de polissage selon l'une quelconque des revendications 2 à 6, dans lequel une teneur du polymère A est 0,001 à 0,1 partie en masse par rapport à 100 parties en masse du liquide de polissage CMP.

8. Procédé de polissage selon l'une quelconque des revendications 1 à 7, dans lequel le polymère cationique inclut le polymère d'allylamine B.

9. Procédé de polissage selon la revendication 8, dans lequel le polymère d'allylamine B inclut un polymère présentant un sel de diallyl dialkyl ammonium en tant qu'une unité monomère.

10. Procédé de polissage selon la revendication 8 ou 9, dans lequel une teneur du polymère B est 0,001 à 0,01 partie en masse par rapport à 100 parties en masse du liquide de polissage CMP.

11. Procédé de polissage selon l'une quelconque des revendications 1 à 10, dans lequel les grains abrasifs contiennent un composé à base de cérium.

12. Procédé de polissage selon la revendication 11, dans lequel le composé à base de cérium inclut un oxyde de cérium.

13. Procédé de polissage selon l'une quelconque des revendications 1 à 12, dans lequel les grains abrasifs ne contiennent pas un hydroxyde.

14. Procédé de polissage selon l'une quelconque des revendications 1 à 13, dans lequel une teneur des grains abrasifs est 0,1 à 2 parties en masse par rapport à 100 parties en masse du liquide de polissage CMP.

15. Procédé de polissage selon l'une quelconque des revendications 1 à 14, dans lequel un pH du liquide de polissage CMP est 7,0 ou moins.

16. Procédé de polissage selon l'une quelconque des revendications 1 à 15, dans lequel un pH du liquide de polissage CMP est 2,0 à 5,0.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013175731 A
- US 2016053381 A1